# FASCICULE DE BREVET EUROPEEN

(11) **EP 3 811 745 B1**
(45) Date de publication et mention de la délivrance du brevet: **16.04.2025**
(21) Numéro de dépôt: 19729791.4
(22) Date de dépôt: 17.06.2019
(51) Int. Cl.: H05K 7/14

(54) **SYSTEME D'INTERCONNEXION POUR UNE BAIE D'UN SYSTEME D'UN AERONEF**
VERBINDUNGSSYSTEM FÜR EIN GESTELL EINES FLUGZEUGSYSTEMS
INTERCONNECTION SYSTEM FOR A RACK OF A SYSTEM OF AN AIRCRAFT

(30) Priorité: 22.06.2018 FR 1855582
(43) Date de publication de la demande: 28.04.2021
(73) Titulaire: Latelec, 31676 Labege Cedex (FR)
(72) Inventeur: AGUERA, Damien, 31170 TOURNEFEUILLE (FR); MARIN, Yannick, 31530 LE CASTERA (FR); BANASIAK, Vincent, 31140 AUCAMVILLE (FR); PUERTOLAS, Bastien, 31280 AIGREFEUILLE (FR)
(74) Mandataire: Cabinet Le Guen Maillet
(86) Numéro de dépôt international: PCT/EP2019/065875
(87) Numéro de publication internationale: WO 2019/243251

(56) Documents cités:
- EP-A1- 3 008 983
- FR-A1- 2 927 222
- FR-A1- 2 977 447
- US-A1- 2004 100 783

## Description

La présente invention concerne le domaine des systèmes embarqués dans un avion. L'invention concerne plus particulièrement un système d'interconnexion pour une baie d'un système d'un aéronef. Les documents FR2977477A1 et EP3008983A1 divulguent de tels systèmes d'interconnexion, selon l'état de l'art.

Un aéronef comporte une multitude de systèmes comprenant des dispositifs électroniques fournissant diverses fonctions (systèmes avioniques, systèmes de navigation, détecteurs de fumée, calculateurs d'alarmes, systèmes électriques, systèmes de climatisation, systèmes de divertissement pour des passagers...). Afin de faciliter la maintenance, ces dispositifs électroniques des systèmes sont rendus aisément remplaçables en étant montés de façon amovible dans des châssis d'une baie. Cela permet par exemple à un opérateur d'extraire de son châssis un dispositif électronique fautif pour le remplacer par un autre dispositif électronique fournissant la même fonction, ou bien d'installer un nouveau dispositif électronique fournissant d'autres fonctions à la place d'un dispositif électronique. On parle d'Unité Remplaçable en Piste (ci-après URP, ou LRU pour « *Line Replaceable Unit* » en anglais). Chaque dispositif électronique peut donc être inséré dans un châssis (ou emplacement d'accueil) d'une baie avionique destinée à accueillir une pluralité de dispositifs électroniques. Une baie avionique peut correspondre à une armoire comportant une ou plusieurs étagères, chaque étagère pouvant comprendre un ou plusieurs châssis, chaque châssis étant adapté pour accueillir un dispositif électronique de type URP.

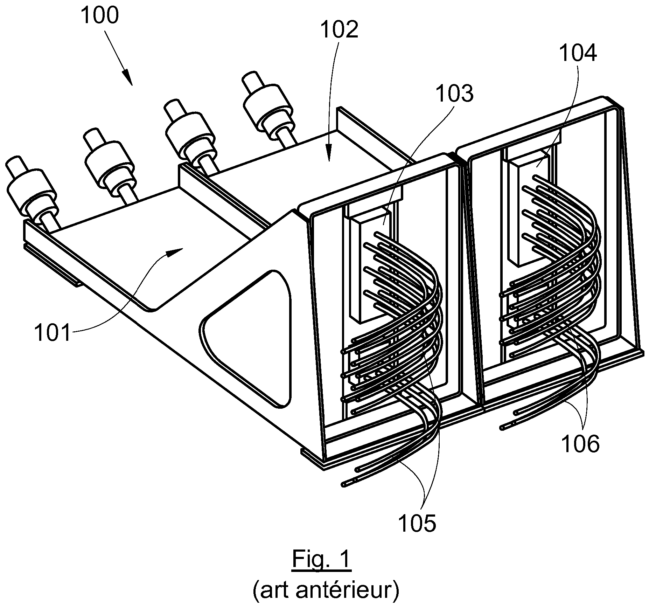

La **Fig. 1** illustre ainsi une baie 100 comportant deux châssis 101 et 102 d'un système d'un aéronef, les deux châssis étant sur une même étagère de la baie 100. Les châssis 101 et 102 sont adaptés pour recevoir chacun un dispositif électronique ou URP. Lorsqu'un dispositif électronique est installé dans le châssis 101, respectivement 102, un connecteur intégré audit dispositif électronique vient se connecter au connecteur 103, respectivement au connecteur 104. Typiquement, les châssis 101 et 102, ainsi que les connecteurs 103 et 104, sont conformes à une norme, par exemple la norme « *ARINC 600* » (pour « *Aeronautical Radio, Incorporated* » en anglais). Chaque connecteur des châssis doit être câblé au système de l'aéronef. Ainsi, l'ensemble des câbles 105, respectivement des câbles 106, permet une connexion du dispositif électronique installé dans le châssis 101, respectivement le châssis 102, au système de l'aéronef. Chaque connecteur, par exemple les connecteurs 103 et 104, de chaque châssis de chaque étagère de la baie doit ainsi être câblé au système de l'aéronef. Cette solution présente des inconvénients.

Tout d'abord, l'ensemble des câbles utilisés finit par représenter un certain poids, et, conséquemment, un certain coût. De même, les systèmes avioniques comportant de plus en plus de dispositifs électroniques, les câbles finissent par occuper un volume significatif autour des baies de ces systèmes avioniques, et leur mise en œuvre est longue et complexe. Outre le fait que le volume est limité dans un aéronef, cela peut poser des problèmes d'accessibilité lors de la maintenance de l'aéronef.

Ensuite, le câblage d'un châssis nécessite fréquemment d'être refait ou *a minima* modifié lorsqu'un dispositif électronique installé dans le châssis est remplacé par un autre dispositif électronique offrant par exemple d'autres fonctions. L'opération de câblage nécessaire est une opération délicate, devant être réalisée par du personnel qualifié, et coûtant du temps de maintenance. Le coût en temps de maintenance est d'autant plus important qu'une étape de vérification de la bonne réalisation du câblage est nécessaire.

Il est donc nécessaire de proposer un système d'interconnexion pour une baie d'un système d'un aéronef permettant de pallier ces inconvénients.

L'invention concerne un système d'interconnexion pour une baie d'un système d'un aéronef, le système d' interconnexion comprenant:
- au moins une étagère comprenant au moins un châssis, chaque châssis étant adapté pour recevoir un dispositif électronique, chaque châssis comprenant un connecteur permettant, d'un premier côté, une connexion dudit dispositif électronique, et, d'un deuxième côté, une connexion au système de l'aéronef,
- un panneau dit arrière, constitué d'un circuit imprimé, le panneau arrière comprenant :
   - autant de raccords que de connecteurs de l'étagère, chaque raccord étant connecté à un deuxième côté d'un connecteur correspondant,
   - au moins une interface pour connecter un panneau dit latéral,
- le panneau dit latéral, constitué d'une carte électronique, le panneau latéral comprenant :
   - au moins une interface pour connecter le panneau dit arrière,
   - une pluralité de connecteurs permettant une connexion au système de l'aéronef,
le circuit imprimé du panneau arrière permettant un ensemble de liaisons électriques prédéfinies entre les connecteurs et l'interface, la carte électronique du panneau latéral permettant l'établissement d'un ensemble de liaisons électriques entre l'interface et les connecteurs vers le système de l'aéronef. Chaque deuxième côté de chaque connecteur de l'étagère comprend une partie souple destinée à venir en appui sur un raccord du panneau arrière, chaque partie souple comprenant des liaisons électriques intégrées. Chaque raccord du panneau arrière comprend une pluralité de contacts électriques, et chaque deuxième côté des connecteurs de l'étagère venant en appui souple sur un raccord du panneau arrière lorsque le panneauarrière est fixé solidairement à l'étagère.

Avantageusement, le système d'interconnexion permet de se passer de câbles précédemment décrits, d'où un gain de volume et un coût réduit. Ces câbles sont remplacés par une association d'un panneau dit arrière et d'un panneau dit latéral. Le panneau arrière, comprenant un circuit imprimé, permet de renvoyer tous les câblages issus des châssis de chaque étagère vers le panneau latéral, celui-ci permettant une interconnexion vers un système d'un aéronef. Le panneau arrière est un élément passif, ne nécessitant pas de maintenance. Le circuit imprimé peut comprendre une multitude de configurations prédéfinies de câblages nécessaires à une baie, ce qui évite toute opération de recâblage lorsqu'un dispositif électronique d'un châssis est modifié. La maintenance en est facilitée. Il est à noter que l'installation d'une baie est aussi grandement facilitée, l'opération fastidieuse de câblage de l'ensemble des connecteurs des châssis d'une étagère d'une baie étant remplacée par une installation d'un panneau arrière.

Selon un mode de réalisation complémentaire de l'invention, le circuit imprimé du panneau arrière est un circuit imprimé multicouches.

Selon un mode de réalisation complémentaire de l'invention, le circuit imprimé du panneau arrière comprend une liaison électrique reliée à une pluralité des liaisons électriques issues des connecteurs.

Selon un mode de réalisation complémentaire de l'invention, le circuit imprimé du panneau arrière comprend une liaison électrique reliée d'un côté à une interface de sortie du panneau arrière destinée à être connectée à une masse de l'étagère et, d'un autre côté, à une pluralité des liaisons électriques issues des connecteurs.

Selon un mode de réalisation complémentaire de l'invention, le panneau latéral étant intégré dans un dispositif électronique pouvant prendre place dans un châssis de l'étagère, l'interface entre le panneau latéral et le panneau arrière est le connecteur dudit châssis.

Selon un mode de réalisation complémentaire de l'invention, le circuit électronique du panneau latéral est adapté pour réaliser des fonctions de commutations entre les liaisons électriques, réaliser des fonctions dites de « programmation de broches de matériel » sur les liaisons électriques et/ou convertir un signal électrique, respectivement optique, en un signal optique, respectivement électrique. Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la **Fig. 1** illustre schématiquement une étagère d'une baie d'un système d'un aéronef comprenant deux châssis telle que connue de l'homme du métier,
- la **Fig. 2** illustre schématiquement une étagère d'une baie d'un système d'un aéronef comprenant trois châssis, vue de dessus, telle que connue de l'homme du métier,
- la **Fig. 3** illustre schématiquement une étagère d'une baie d'un système d'un aéronef, vue de dessus, comprenant un système d'interconnexion selon un mode de réalisation de l'invention,
- les **Figs. 4A à 4D** illustrent schématiquement une interconnexion entre un ou plusieurs connecteurs de châssis avec un panneau arrière selon différents modes de réalisation de l'invention,
- la **Fig. 5** illustre schématiquement une étagère d'une baie d'un système d'un aéronef, vue de dessus, comprenant un système d'interconnexion selon un mode de réalisation alternatif de l'invention.

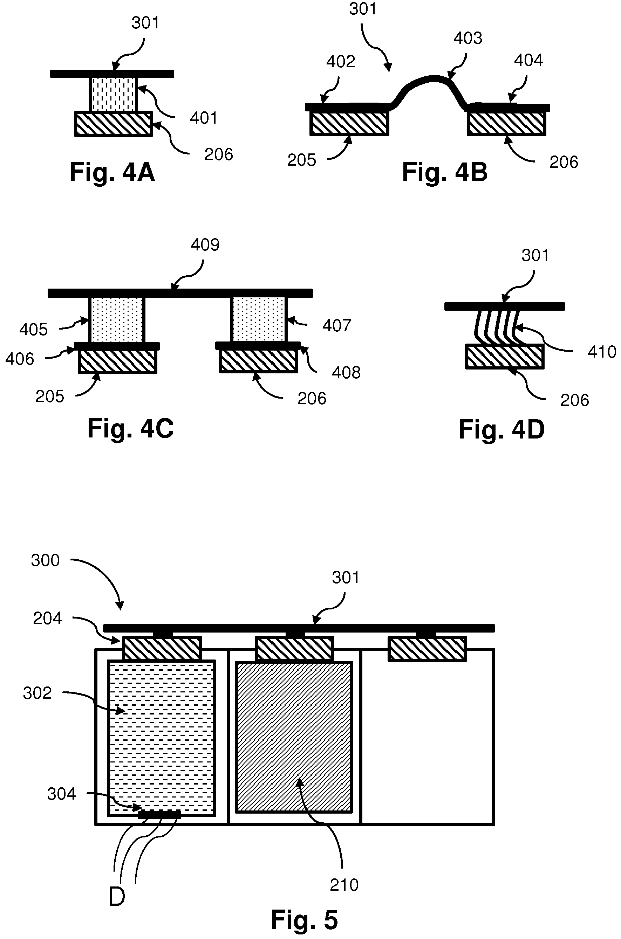

Les modes de réalisations décrits aux Figs. 4B,4C,4D et 5 ne relèvent pas de l'invention et ne sont présents qu'à titre illustratif.

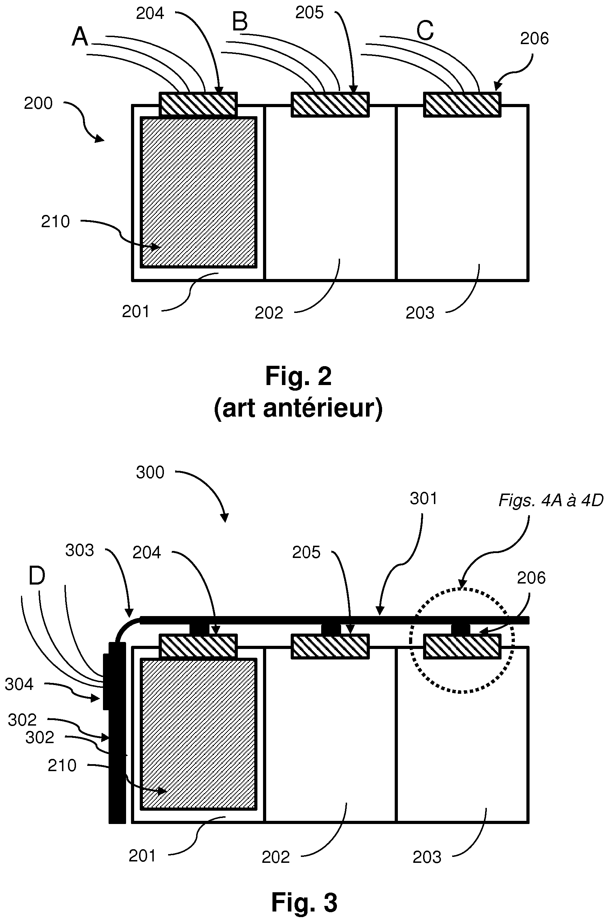

La Fig. 2 illustre schématiquement une étagère d'une baie 200 d'un système d'un aéronef, comprenant trois châssis 201, 202 et 203, vue de dessus, telle que connue de l'homme du métier. Typiquement, l'étagère de la baie 200, ainsi que les châssis et connecteurs, sont conformes à une norme, par exemple la norme « *ARINC 600* »*.*

Dans cet exemple, un dispositif électronique (ou URP) 210 est inséré dans le châssis 201. Chaque châssis 201, 202 ou 203 comprend un connecteur 204, 205 ou 206 permettant de connecter, via des câblages A, B ou C, un dispositif électronique installé dans le châssis correspondant. L'ensemble des câbles A, B et C peut comprendre une multitude de câbles électriques. La multiplication des châssis similaires aux châssis 201, 202 et 203 dans chaque étagère d'une baie peut finir par représenter un volume et un poids de câble conséquent. De plus, les câblages A, B et C étant situés à l'arrière de chaque étagère de la baie 200, l'accès peut être délicat.

La **Fig. 3** illustre schématiquement une étagère d'une baie 300 d'un système d'un aéronef, vue de dessus, comprenant un système d'interconnexion selon un mode de réalisation de l'invention. Typiquement, l'étagère de la baie 300, ainsi que les châssis et connecteurs, sont conformes à une norme, par exemple la norme « *ARINC 600* ». L'étagère de la baie 300 correspond à l'étagère de la baie 200 pour laquelle la solution technique présentée dans le présent document a été installée. Chaque châssis 201, 202 et 203 est adapté pour recevoir un dispositif électronique (par exemple 210) et comprend un connecteur 204, 205 ou 206 permettant, d'un premier côté, une connexion dudit dispositif électronique, et, d'un deuxième côté, une connexion au système de l'aéronef, via le câblage A, B ou C. Dit autrement, l'étagère de la baie 300 correspond à l'étagère de la baie 200 pour laquelle les câblages A, B et C au système de l'aéronef ont été avantageusement supprimés et remplacés par:
- un panneau 301 dit arrière, constitué d'un circuit imprimé, le panneau arrière comprenant :
   o autant de raccords que de connecteurs 204, 205 et 206 de l'étagère, chaque raccord étant connecté à un deuxième côté d'un connecteur 204, 205 ou 206 correspondant,
   o au moins une interface 303 pour connecter un panneau dit latéral,
- le panneau 302 dit latéral, constitué d'une carte électronique, le panneau latéral comprenant :
   o au moins une interface 303 pour connecter le panneau dit arrière,
   o une pluralité de connecteurs 304 permettant une connexion à un système de l'aéronef.

Il est à noter que les appellations du panneau 301 dit arrière et du panneau 302 dit latéral correspondent à leurs positions relativement à l'étagère selon un mode de réalisation de l'invention. Ces positions relativement à l'étagère de chaque panneau peuvent toutefois varier selon le mode de réalisation de l'invention. En particulier, le panneau 302 dit latéral peut avoir une autre position qu'une position latérale relativement à l'étagère. Le panneau dit latéral peut ainsi être disposé en face avant d'un châssis dédié, comme décrit ci-après. Le circuit imprimé du panneau arrière 301 permet un ensemble de liaisons électriques prédéfinies entre les connecteurs 204, 205 et 206 et l'interface 303. La carte électronique du panneau latéral 302 permet l'établissement d'un ensemble de liaisons électriques entre l'interface 303 - et donc les connecteurs 204, 205 et 206 - et les connecteurs 304 vers le système de l'aéronef.

Ainsi, les câbles A, B et C de la Fig. 2 sont supprimés, et remplacés par une collecte des liaisons électriques issues des connecteurs 204, 205 et 206 par le circuit imprimé du panneau arrière 301, puis par un possible multiplexage, commutation, mise à la masse, mise à un niveau équipotentiel, conversion en un signal optique par le panneau latéral 302. L'interconnexion proprement dite à un système de l'aéronef se fait alors via le connecteur 304 du panneau latéral 302 via le câblage D. Le câblage D ne nécessite que d'être réalisé une seule fois lors de l'installation de chaque étagère de la baie. Le câblage D reprend le câblage existant vers le système de l'aéronef, ce qui rend la solution technique présentée compatible avec les aéronefs existants sans devoir refaire ou remplacer tout le câblage de l'aéronef.

Selon un mode de réalisation complémentaire de l'invention, le circuit imprimé du panneau arrière 301 est un circuit imprimé multicouche. Ainsi, il est possible d'agencer des signaux électriques de différentes natures (signaux électriques discrets, rapides, de puissance, etc.) au sein de circuits intégrés à différentes couches du circuit imprimé sans que ceux-ci ne se perturbent l'un l'autre. Un même circuit imprimé multicouche remplace donc une multitude de câbles pour un gain en termes de poids et de volume.

Le circuit imprimé du panneau arrière 301 peut comprendre des circuits permettant une mise à la masse ou à un niveau équipotentiel de différentes liaisons électriques issues des connecteurs des châssis. Le panneau arrière 301 peut alors comprendre une ou plusieurs interfaces (non représentées) permettant une mise à la masse desdits circuits à la masse du système de l'aéronef. Les modules de masses ou les modules équipotentiels sont donc avantageusement remplacés, avec là aussi un gain en termes de poids et de volume.

Le circuit imprimé du panneau arrière peut comprendre une multitude de liaisons électriques prédéfinies, par exemple des liaisons électriques en provision. Ces liaisons électriques sont alors réalisées sans aucun surcoût en termes de poids ou de volume puisqu'intégrées au circuit imprimé.

Les **Figs. 4A à 4D** illustrent schématiquement une interconnexion entre un ou plusieurs connecteurs 204, 205 et 206 de châssis avec un panneau arrière selon différents modes de réalisation de l'invention. L'objet des différentes solutions présentées dans les Figs. 4A à 4D est de permettre un découplage mécanique entre le panneau arrière 301, rigide, et devant être protégé des sollicitations mécaniques, et les autres éléments de chaque étagère de la baie. Les Figs. 4A à 4D illustrent le détail de la Fig. 3 délimité par un cercle en pointillés autour du connecteur 206 sur la Fig. 3.

La Fig. **4A** illustre une première solution technique permettant un découplage entre le panneau arrière 301 et les éléments de l'étagère de la baie 300. Dans cette solution, chaque deuxième côté de chaque connecteur 204, 205 et 206 de l'étagère de la baie 300 comprend une partie souple 401 destinée à venir en appui sur un raccord du panneau arrière, chaque partie souple 401 comprenant un câblage électrique intégré. Chaque raccord du panneau arrière comprend une pluralité de contacts électriques, les contacts électriques étant en regard du câblage électrique de la partie souple 401. Ainsi, lorsque le panneau 301 est fixé à l'arrière de l'étagère de la baie 300, il est monté en appui sur ces parties souples 401, ce qui garantit d'une part l'établissement des liaisons électriques, et d'autre part un découplage mécanique via la souplesse des parties souples 401. Les connecteurs 204, 205 et 206 doivent préalablement avoir été modifiés. Le montage du panneau arrière 301 en appui sur les parties souples est particulièrement aisé.

La Fig. **4B** illustre une deuxième solution technique permettant un découplage entre le panneau arrière 301 et les éléments de l'étagère de la baie 300. Dans cette solution, le circuit imprimé du panneau arrière 301 est constitué de différentes parties : certaines parties du circuit imprimé sont souples, d'autres sont rigides. Les parties rigides 402 et 404 du circuit imprimé sont celles comprenant les raccords. Ces parties rigides sont fixées sur chaque deuxième côté des connecteurs 204, 205 ou 206 de l'étagère de la baie 300. Les parties souples 403 du circuit imprimé du panneau arrière 301 sont celles situées entre deux parties rigides. Le panneau arrière est ainsi constitué d'une succession de parties rigides et souples, les parties rigides permettant d'assurer une connexion aux connecteurs 204, 205 et 206 de l'étagère de la baie 300, les parties souples assurant un découplage mécanique entre les différentes parties rigides du panneau arrière (chaque connecteur 204, 205 ou 206 pouvant varier légèrement de position indépendamment des autres connecteurs). Le circuit imprimé constituant le panneau arrière 301 est dit « *flex-rigide* »*.* Dans cette solution, les connecteurs 204, 205 et 206 ne sont pas modifiés. Cette solution permet un assemblage aisé du panneau arrière 301 sur l'étagère de la baie 300.

La Fig. **4C** illustre une troisième solution technique permettant un découplage entre le panneau arrière 301 et les éléments de l'étagère de la baie 300. Dans cette solution, le circuit imprimé du panneau arrière 301 est constitué de différentes parties :
- une pluralité de parties rigides 406 et 408 dites de connexion, comprenant les raccords, disposées en regard de chaque deuxième côté des connecteurs 205 et 206 de l'étagère de la baie 300,
- une partie rigide 409 dite de routage, comprenant un routage des liaisons électriques du circuit imprimé, la partie rigide étant fixée solidairement avec l'étagère de la baie 300, et,
- une pluralité de parties souples 405 et 407 permettant une connexion de chaque partie rigide de connexion avec la partie rigide de routage.

Dit autrement, le panneau arrière 301 est divisé en deux parties :
- une partie de routage 409, similaire structurellement au panneau arrière 301, d'une pièce, comprend le routage des liaisons électriques, et autant d'interfaces que des connecteurs 204, 205 et 206,
- une pluralité de parties de connexion 406 ou 408, autant que de connecteurs, chaque partie de connexion étant connectée sur un connecteur 204, 205 ou 206, et,
- des parties souples 405 et 407 permettant de connecter les parties de connexion à la partie de routage.

Selon un mode de réalisation de l'invention, au moins une partie rigide dite de connexion est interchangeable afin d'être adaptée à un type de connecteur d'un châssis de l'étagère de la baie. En effet, le type de connecteur de chaque châssis peut varier selon l'équipement à accueillir ou une norme suivie. Cette solution permet avantageusement de remplacer une partie de connexion par une autre si un connecteur d'un châssis de l'étagère de la baie 300 change de format, sans pour cela changer tout le panneau arrière. Il suffit alors de déconnecter la partie de connexion correspondante pour la remplacer par une autre adaptée au nouveau connecteur. Les parties souples 405 et 407 sont typiquement un circuit imprimé souple ou une nappe de connexion.

La Fig. **4D** illustre une quatrième solution technique permettant un découplage entre le panneau arrière et les éléments de l'étagère de la baie 300. Dans cette solution, les liaisons électriques entre les deuxièmes côtés des connecteurs 204, 205 et 206 et les raccords correspondants du panneau arrière 301 sont réalisées par des nappes de câbles et/ou des fils électriques 410. L'avantage de cette solution est que le circuit imprimé peut être un circuit imprimé classique rigide, ce qui diminue la complexité, et donc le coût, de la solution.

La **Fig. 5** illustre schématiquement l'étagère de la baie 300 d'un système d'un aéronef, vue de dessus, comprenant un système d'interconnexion selon un mode de réalisation alternatif de l'invention. Dans cette solution, le panneau latéral 302 prend la forme d'un dispositif électronique 302. Ledit dispositif électronique peut alors être inséré, tout comme n'importe quel LRU, dans l'étagère de la baie 300. L'interface de connexion 303 entre le panneau arrière 301 et le panneau latéral 302 est avantageusement le connecteur 204.

Dans la présente solution, le panneau latéral 302 peut comprendre des composants électroniques permettant la réalisation d'une multitude de fonctions. Ainsi, le panneau latéral 302 peut être adapté afin de réaliser des fonctions de commutations entre les différentes liaisons électriques provenant du panneau arrière 301. La commutation peut être réalisée par des composants permettant une commutation par relais ou par filtrage. Le panneau latéral 302 peut être adapté afin de réaliser des fonctions dites de « *programmation de broches de matériel* » sur les liaisons électriques issues du panneau arrière 301. Dit autrement, le panneau latéral 302 peut intégrer des composants permettant une fonction de type « *programmation de broches de matériel* » (« *Hardware Pin Programming* » ou en anglais). Une pluralité de connecteurs 304 permet une connexion au système de l'aéronef. La pluralité des connecteurs 304 peut être positionnée sur n'importe quelle face du panneau latéral 302, par exemple la face avant dans l'exemple illustré. Le panneau latéral 302 peut être adapté afin de convertir un signal électrique, respectivement optique, en un signal optique, respectivement électrique. Le panneau latéral 302 peut ainsi permettre une interconnexion de l'étagère de la baie vers le système de l'aéronef via des fibres optiques, le panneau latéral 302 intégrant des convertisseurs optoélectroniques. Le panneau latéral 302 peut aussi comprendre des composants permettant une protection contre la foudre provenant du câblage du système de l'aéronef afin de protéger les dispositifs électroniques de l'étagère de la baie 300.

Le câblage d'une étagère d'une baie peut être ainsi virtuellement mis à jour rapidement par simple paramétrage ou configuration du panneau latéral 302 (paramétrage logiciel ou via des interrupteurs physiques sur le panneau latéral 302). Il peut être possible de remplacer uniquement le panneau latéral 302, sans devoir toucher au panneau arrière 301, afin de mettre à jour ou adapter le « *câblage* » du système de l'aéronef. La remise à plat ou modification d'un câblage d'une étagère d'une baie, opération précédemment longue et fastidieuse, peut être ainsi remplacée par un simple échange du composant panneau latéral 302.

## Revendications

1. Système d'interconnexion pour une baie d'un système d'un aéronef, le système d'interconnexion comprenant :
- au moins une étagère (200, 300) comprenant au moins un châssis (201, 202, 203), chaque châssis étant adapté pour recevoir un dispositif électronique (210), chaque châssis comprenant un connecteur (204, 205, 206) permettant, d'un premier côté, une connexion dudit dispositif électronique, et, d'un deuxième côté, une connexion au système de l'aéronef,
- un panneau dit arrière (301), constitué d'un circuit imprimé, le panneau arrière comprenant :
• autant de raccords que de connecteurs de l'étagère, chaque raccord étant connecté à un deuxième côté d'un connecteur correspondant,
• au moins une interface pour connecter un panneau dit latéral,
- le panneau dit latéral (302), constitué d'une carte électronique, le panneau latéral comprenant :
• au moins une interface pour connecter le panneau dit arrière,
• une pluralité de connecteurs permettant une connexion au système de l'aéronef,
le circuit imprimé du panneau arrière permettant un ensemble de liaisons électriques prédéfinies entre les connecteurs et l'interface, la carte électronique du panneau latéral permettant l'établissement d'un ensemble de liaisons électriques entre l'interface et les connecteurs vers le système de l'aéronef, le système d'interconnexion étant **caractérisé en ce que** :
- chaque deuxième côté de chaque connecteur de l'étagère comprend une partie souple (401) destinée à venir en appui sur un raccord du panneau arrière, chaque partie souple comprenant des liaisons électriques intégrées,
- chaque raccord du panneau arrière comprenant une pluralité de contacts électriques, et chaque deuxième côté des connecteurs venant en appui souple sur un raccord du panneau arrière lorsque le panneau arrière est fixé solidairement à l'étagère.

2. Système d'interconnexion selon la revendication 1, **caractérisé en ce que** le circuit imprimé du panneau arrière est un circuit imprimé multicouches.

3. Système d'interconnexion selon l'une des revendications précédentes, **caractérisé en ce que** le circuit imprimé du panneau arrière comprend une liaison électrique reliée à une pluralité des liaisons électriques issues des connecteurs.

4. Système d'interconnexion selon l'une des revendications précédentes, **caractérisé en ce que** le circuit imprimé du panneau arrière comprend une liaison électrique reliée :
• d'un côté à une interface de sortie du panneau arrière destinée à être connectée à une masse de l'étagère, et,
• d'un autre côté, à une pluralité des liaisons électriques issues des connecteurs.

5. Système d'interconnexion selon l'une des revendications précédentes, **caractérisé en ce que**, le panneau latéral étant intégré dans un dispositif électronique (302) pouvant prendre place dans un châssis de l'étagère, l'interface entre le panneau latéral et le panneau arrière est le connecteur dudit châssis.

6. Système d'interconnexion selon l'une des revendications précédentes, **caractérisé en ce que** le circuit électronique du panneau latéral est adapté pour :
• réaliser des fonctions de commutations entre les liaisons électriques, et/ou,
• réaliser des fonctions dites de « programmation de broches de matériel » sur les liaisons électriques, et/ou,
• convertir un signal électrique, respectivement optique, en un signal optique, respectivement électrique.

## Patentansprüche

1. Verbindungssystem für ein Rack eines Luftfahrzeugsystems, das Verbindungssystem umfasst:
- Mindestens ein Regal (200, 300) mit mindestens einem Rahmen (201, 202, 203), wobei jeder Rahmen für die Aufnahme einer elektronischen Vorrichtung (210) ausgelegt ist, wobei jeder Rahmen einen Anschluss (204, 205, 206) zum Verbinden der elektronischen Vorrichtung auf einer ersten und auf einer zweiten Seite aufweist; Eine Verbindung zum Luftfahrzeugsystem,
- Eine so genannte Rückwand (301), bestehend aus einer gedruckten Schaltung, wobei die Rückwand aus
• So viele Anschlüsse wie Anschlüsse auf dem Regal, wobei jedes Anschlussstück mit einer zweiten Seite eines entsprechenden Anschlussstücks verbunden ist,
• Mindestens eine Schnittstelle zum Anschluss einer so genannten Seitenwand,
- Das so genannte Seitenteil (302), bestehend aus einer elektronischen Karte, das Seitenteil umfasst:
• Mindestens eine Schnittstelle zum Anschluss der so genannten Rückwand,
• Mehrere Anschlüsse für den Anschluss an das Luftfahrzeugsystem,
Die Leiterplatte auf der Rückseite ermöglicht einen Satz vordefinierter elektrischer Verbindungen zwischen den Steckverbindern und der Schnittstelle, wobei die elektronische Leiterplatte der Seitenplatte die Einrichtung eines Satzes elektrischer Verbindungen zwischen der Schnittstelle und den Steckverbindern zum Luftfahrzeugsystem ermöglicht, wobei das Verbindungssystem **dadurch gekennzeichnet ist, dass**:
- Jede zweite Seite jedes Steckers der Ablage besteht aus einem flexiblen Teil (401), das auf einem Stecker der Rückwand angebracht werden soll, wobei jedes flexible Teil integrierte elektrische Verbindungen aufweist;
- Jeder Steckverbinder der Rückwand besteht aus mehreren elektrischen Kontakten, und jede zweite Seite der Anschlüsse wird flexibel auf einem Anschluss der Rückwand angebracht, wenn die Rückwand fest in der Ablage befestigt ist.

2. Verbindungssystem nach Anspruch 1, **dadurch gekennzeichnet, daß** die Rückwandplatine-Leiterplatte eine mehrschichtige Leiterplatte ist.

3. Verbindungssystem nach einem der vorhergehenden Ansprüche, **dadurch gekennzeichnet, dass** die Leiterplatte der Rückwand eine elektrische Verbindung aufweist, die mit einer Vielzahl der elektrischen Verbindungen verbunden ist, die von den Steckverbindern ausgehen.

4. Verbindungssystem nach einem der vorangehenden Ansprüche, **dadurch gekennzeichnet, dass** die Leiterplatte der Rückwand eine elektrische Verbindung umfasst, die angeschlossen ist:
• Auf einer Seite an einer rückseitigen Ausgabeschnittstelle, die an eine Regalerde angeschlossen werden soll, und
• Auf der anderen Seite an mehrere elektrische Anschlüsse, die von den Steckverbindern ausgehen.

5. Verbindungssystem nach einem der vorhergehenden Ansprüche, **dadurch gekennzeichnet, dass** die Seitenverkleidung in eine elektronische Vorrichtung (302) integriert ist, die in ein Chassis des Fachs eingesetzt werden kann, die Schnittstelle zwischen der Seitenverkleidung und der Rückverkleidung der Anschluss des Chassis ist.

6. Verbindungssystem nach einem der vorangehenden Ansprüche, **dadurch gekennzeichnet, dass** die elektronische Schaltung der Seitenverkleidung angepasst ist, um:
• Umschaltfunktionen zwischen elektrischen Anschlüssen durchführen und/oder
• So genannte "Hardware-PIN-Programmierung" an elektrischen Anschlüssen durchführen und/oder
• Wandeln Sie ein elektrisches bzw. optisches Signal in ein optisches bzw. elektrisches Signal um.

## Claims

1. Interconnection system for a rack of a system of an aircraft, the interconnection system comprising:
- at least one shelf (200, 300) comprising at least one frame (201, 202, 203), each frame being adapted to receive an electronic device (210), each frame comprising a connector (204, 205, 206) allowing, on a first side, a connection of said electronic device, and, on a second side, a connection to the system of the aircraft,
- a so-called rear panel (301), consisting of a printed circuit, the rear panel comprising:
• as many coupling fittings as connectors of the shelf, each coupling fitting being connected to a second side of a corresponding connector,
• at least one interface for connecting a so-called lateral panel,
- the so-called lateral panel (302), consisting of an electronic circuit board, the lateral panel comprising:
• at least one interface for connecting the so-called rear panel,
• a plurality of connectors allowing a connection to the system of the aircraft,
the printed circuit of the rear panel allowing a set of predefined electrical links between the connectors and the interface, the electronic circuit board of the lateral panel allowing a set of electrical links to be set up between the interface and the connectors to the system of the aircraft, the interconnection system being **characterized in that**:
- each second side of each connector of the shelf comprises a flexible part (401) intended to come to bear on a coupling fitting of the rear panel, each flexible part comprising integrated electrical links,
- each coupling fitting of the rear panel comprising a plurality of electrical contacts, and each second side of the connectors coming to bear flexibly on a coupling fitting of the rear panel when the rear panel is securely fixed to the shelf.

2. Interconnection system according to Claim 1, **characterized in that** the printed circuit of the rear panel is a multilayer printed circuit.

3. Interconnection system according to either of the preceding claims, **characterized in that** the printed circuit of the rear panel comprises an electrical link linked to a plurality of electrical links from the connectors.

4. Interconnection system according to one of the preceding claims, **characterized in that** the printed circuit of the rear panel comprises an electrical link linked:
• on one side to an output interface of the rear panel intended to be connected to a ground of the shelf, and,
• on another side, to a plurality of electrical links from the connectors.

5. Interconnection system according to one of the preceding claims, **characterized in that**, the lateral panel being incorporated in an electronic device (302) that can fit in a frame of the shelf, the interface between the lateral panel and the rear panel is the connector of said frame.

6. Interconnection system according to one of the preceding claims, **characterized in that** the electronic circuit of the lateral panel is adapted to:
• perform switching functions between the electrical links, and/or
• perform so-called "hardware pin programming" functions on the electrical links, and/or
• convert an electrical, respectively optical, signal into an optical, respectively electrical, signal.
